# EUROPEAN PATENT SPECIFICATION

(11) **EP 4 528 796 B1**
(45) Date of publication and mention of the grant of the patent: **11.03.2026**
(21) Application number: 23198602.7
(22) Date of filing: 20.09.2023
(51) Int. Cl.: H01L 21/768, H01L 23/528, H01L 23/535, H01L 21/74

(54) **METHOD FOR FORMING A BURIED INTERCONNECT STRUCTURE**
VERFAHREN ZUR HERSTELLUNG EINER VERGRABENEN VERBINDUNGSSTRUKTUR
PROCÉDÉ DE FORMATION D'UNE STRUCTURE D'INTERCONNEXION ENTERRÉE

(43) Date of publication of application: 26.03.2025
(73) Proprietor: Imec VZW, 3001 Leuven (BE)
(72) Inventor: HIBLOT, Gaspard, deceased (BE); MIRABELLI, Gioele, 3000 Leuven (BE)
(74) Representative: Lind Edlund Kenamets Intellectual Property AB

(56) References cited:
- US-A1- 2020 135 634
- US-A1- 2023 139 929
- US-A1- 2023 154 783
- US-A1- 2023 163 020

## Description

### TECHNICAL FIELD

The present invention generally relates to a method for forming a buried interconnect structure.

### BACKGROUND

Integrated circuits typically comprise power rails (e.g. for VSS and VDD supply voltage distribution). Conventionally, power rails are encapsulated within a back-end-of-line (BEOL) interconnect structure located above the level of the active physical devices (e.g. transistors such as FinFETs or Nanosheet-FETs). In contrast, a "buried" power rail (BPR) is at least partly lowered into the substrate, such that the power rail may be located at a level below the active physical devices. This allows reducing routing congestion in the BEOL. Further, BPRs may be formed with increased cross-sections, thus enabling reduced line resistance, without occupying valuable space in the BEOL.

The local interconnects (e.g. M0A) for the active devices may be connected to a BPR by a so-called Via-to-BPR or power via (PV). A low resistance BPR connection motivates a large contact interface both between the PV and the BPR and between the PV and the local interconnect, and thus an enlargement of both the PV and the local interconnect along the critical dimension (CD), i.e. along the dimension parallel to the substrate and transverse to the BPR. This reduces the spacing along the CD between the local interconnects of laterally adjacent active devices (which e.g. may be disposed on opposite sides along a standard cell boundary).

Thus, a low resistance BPR connection reduces the process margins for PV and local interconnect formation and hence increases the sensitivity to stochastic errors in the integration process, such as overlay errors and over etching.

US2023/139929 A1 discloses a structure containing a via-to-buried power rail contact structure or a via-to-backside power rail contact structure.

### SUMMARY

It is an object of the present invention to provide a method enabling forming of a low resistance connection between a local interconnect and a BPR (or more generally a buried interconnect structure such as a buried metal line), with an improved reliability and process margin. Additional and alternative objects may be appreciated from the following.

Hence, according to an aspect of the present invention, there is provided a method for forming a semiconductor device, the method comprising:
forming a trench for a buried interconnect structure at a position between a first and second fin structure extending in parallel along a substrate, wherein the trench extends through an isolation layer structure embedding the first and second fin structures;
lining the trench with a dielectric layer, the dielectric layer comprising first and second portions formed along opposite first and second sidewalls of the trench;
etching a contact opening in the first portion of the dielectric layer adjacent a first region of the first fin structure, while masking the second portion of the dielectric layer adjacent a second region of the second fin structure directly opposite the first region;
after etching the contact opening, filling the trench with a dielectric material to restore the isolation layer structure over the buried interconnect structure;
forming a local interconnect trench in the isolation layer structure, the local interconnect trench extending between the first and second regions and across the buried interconnect structure, wherein the local interconnect trench is formed by etching the isolation layer structure selectively to the dielectric layer such that the second portion of the dielectric layer is preserved to partition the local interconnect trench into a first trench portion for a first local interconnect and a second trench portion for a second local interconnect, wherein the first trench portion extends through the contact opening in the first portion of the dielectric layer; and
forming a first local interconnect in the first trench portion and a second local interconnect in the second trench portion, wherein the first and second local interconnects are separated by the second portion of the dielectric layer, wherein the second local interconnect contacts a source/drain formed in the second region of the second fin structure, and wherein the first local interconnect comprises a source/drain contact portion contacting a source/drain formed in the first region of the first fin structure, a via portion contacting the buried interconnect structure, and a bridging portion extending between the source/drain contact portion and the via portion through the contact opening.

The method facilitates providing a low resistance via connection to a buried interconnect structure (such as a BPR) by allowing a contact interface between the first local interconnect to be extended along the width dimension of the buried interconnect structure (i.e. across the buried interconnect structure).

The method involves a selective opening of the dielectric layer lining the trench along one lateral sidewall of the trench (the first sidewall) for the buried interconnect structure, which enables the interconnection of the first source/drain portion and the via portion of the first local interconnect by the bridging portion. Meanwhile, the second portion of the dielectric layer directly opposite the contact opening is preserved to ensure a minimum isolation margin between the first local interconnect and the second local interconnect.

The method hence allows the first local interconnect (in particular the bridging portion thereof) to be extended laterally towards the second local interconnect, thereby enabling a reduced isolation margin and CD (i.e. tip-to-tip separation) between neighboring local interconnects (e.g. M0As) while mitigating a risk of shorting.

Since both the source/drain contact portion, the bridging portion and the via portion are formed in the first trench portion of the local interconnect trench, which extends through the contact opening, the location of the via connection may be formed in a self-aligned manner with respect to the source/drain in the first region.

The respective source/drain formed in the first region and the second region of the first and second fin structures, respectively, may typically be formed after restoring the isolation layer structure over the buried interconnect structure, for instance after restoring the isolation layer structure and prior to forming the local interconnect trench.

By the term "buried metal line" is here meant an interconnect structure (dummy or conductive) which is at least partly located below the active level of the transistor devices (which are to be formed). Typically, the interconnect structure may be encapsulated at least partly in a shallow trench isolation (STI) structure embedding a lower portion of the fin structures, and/or at least partly in the substrate. The interconnect structure may be an elongated structure extending in parallel to the fin structures.

By the term "first region" of the first fin structure is here meant a region in which a source/drain of a transistor is to be formed, or has been formed, or alternatively (and equivalently) a region in which a source/drain contact portion of a first local interconnect is to be formed.

By the term "second region" of the second fin structure is here meant a region in which a source/drain of a transistor is to be formed, or has been formed, or alternatively (and equivalently) a region in which a second local interconnect is to be formed, or has been formed.

By the term "fin structure" is here meant pair of elongated semiconductor-comprising bodies, such as a semiconductor fin (e.g. for finFETs) or a stack of horizontally oriented nanosheet stacks (e.g. an alternating stack of sacrificial nanosheets and channel nanosheets).

In some embodiments, the buried interconnect structure is a conductive buried interconnect. The conductive buried interconnect may in particular be a buried conductive line, typically a buried metal line. The buried interconnect may for instance be a buried power rail (BPR).

In some embodiments, the buried interconnect structure is buried dummy interconnect and the method comprises replacing the dummy buried interconnect with a conductive buried interconnect during backside processing. The method is thus compatible with a "replacement approach" for forming a conductive buried interconnect (e.g. a buried conductive line). The replacement approach may mitigate a risk of adversely affecting the first region of the first fin structure due to metal contamination and metal etch during metal deposition and metal etch back when forming a conductive (e.g. metal) interconnect in a non-replacement flow.

In some embodiments, forming the local interconnect trench comprises:
forming an initial local interconnect trench by etching back the isolation layer structure through a first mask opening overlapping the buried interconnect structure, wherein the etch back is stopped prior to exposing the buried interconnect structure; and
forming the local interconnect trench by etching back the isolation layer structure through a second mask opening overlapping the initial interconnect trench and the first and second regions.

The local interconnect trench may thus be formed in two successive etch back steps, thereby allowing control of a width dimension and height dimension of a bottom part of the first trench portion (which will accommodate the via portion) to be decoupled from a depth dimension of an upper part of the first trench portion and of the second trench portion. The first mask opening may be defined to overlap the buried interconnect structure but not the first and second regions.

In some embodiments, the first mask opening further overlaps the second portion of the dielectric layer. The first trench portion, and hence the first local interconnect, may thus be laterally extended to abut / terminate at the second portion of the dielectric layer.

In some embodiments, the first mask opening further overlaps the contact opening in the dielectric layer. A vertical dimension (i.e. depth and height respectively) of the first trench portion, and hence the first local interconnect, may thus be extended at the position of the contact opening.

In some embodiments, buried interconnect structure is formed prior to forming the contact opening in the dielectric layer. The first region of the first fin structure may thus be protected to a greater extent from metal contamination and metal etch during metal deposition and metal etch back when forming a conductive (e.g. metal) interconnect in a non-replacement flow. In this case, while forming the contact opening in the dielectric layer, the dielectric layer may be masked in a bottom portion of the trench by the buried interconnect structure. The dielectric layer may thus be preserved along the sidewalls of the buried interconnect structure.

In some embodiments, the buried interconnect structure is instead formed subsequent to forming the contact opening in the dielectric layer. In this case, while forming the contact opening in the dielectric layer, the dielectric layer may be masked in a bottom portion of the trench by a temporary block layer. The dielectric layer may thus be preserved along the sidewalls of a bottom portion of the buried interconnect structure.

In some embodiments, the isolation layer structure comprises a shallow trench isolation structure embedding a lower portion of the fin structures and an interlayer dielectric layer covering the shallow trench isolation structure and embedding an upper portion of fin structures.

In some embodiments, the trench further extends into the substrate.

In some embodiments, the method further comprises processing the first and second fin structures to form gates across a channel region of the first and second fin structures and source/drains in the first and second regions of the first and second fin structures wherein the contact opening is formed prior to the processing of the first and second fin structures. The buried interconnect structure and the contact opening may thus be formed prior to the gate patterning and source/drain modules of the front-end-of-line processing. The method may hence be incorporated in a streamlined fashion into conventional integration approaches for FinFET and Nanosheet-FET fabrication, without any complex adaption of the existing process steps.

### BRIEF DESCRIPTION OF THE DRAWINGS

This and other aspects of the present invention will now be described in more detail, with reference to the appended drawings showing embodiments of the present invention.
Fig. 1 shows a schematic cross-section of a semiconductor device comprising a BPR and a PV which may be formed using conventional techniques.
Fig. 2 shows a schematic cross-section of a semiconductor device comprising a BPR and a PV which may be formed using embodiments of the present invention.
Fig. 3 shows a schematic cross-section of an initial or precursor structure for a method for forming a buried interconnect structure according to an embodiment.
Fig. 4 shows the structure after forming a trench for a buried interconnect structure in an isolation layer structure and lining the trench with a dielectric layer.
Fig. 5 shows the structure after forming a buried interconnect structure in the trench.
Fig. 6 shows the structure after forming an etch mask for etching a contact opening in the dielectric layer.
Fig. 7 shows the structure after forming the contact opening.
Fig. 8 shows the structure after filling the trench with a dielectric material to restore the isolation layer structure over the buried interconnect structure.
Fig. 9 is a schematic top view of the structure after forming the contact opening in the dielectric layer.
Fig. 10-12 show process steps for forming a local interconnect trench in the isolation layer structure.
Fig. 13 shows the structure after forming a first local interconnect in a first and second trench portion of the local interconnect trench.
Fig. 14 shows the structure after flipping the substrate and forming a backside interconnect structure using backside processing.
Fig. 15 shows the structure after forming a contact opening according to another approach.

### DETAILED DESCRIPTION

Example embodiments and approaches of a method for forming a buried interconnect structure will in the below be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a supporting substrate of the memory structure. The term "vertical" refers to a direction parallel to a normal direction of (the main surface of) the substrate, i.e. transverse to the substrate.

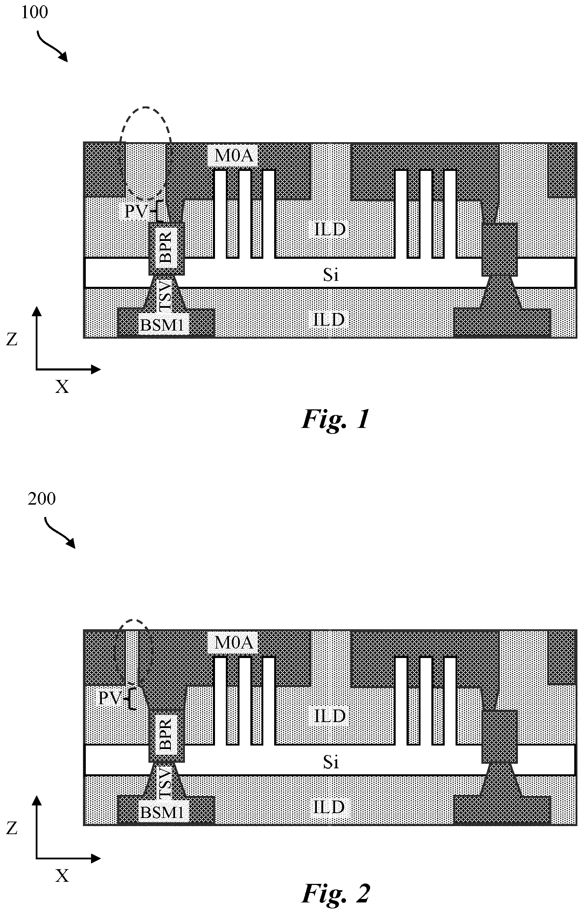

Fig. 1 shows a schematic cross-section of a semiconductor or integrated circuit (IC) device 100 comprising a BPR and a PV. The device 100 further comprises a backside interconnect structure comprising a backside metal layer (BSM1) connected to the BPR by a through-silicon-via (TSV). The BPR and the PV may be formed using conventional techniques. As shown, an additional lateral spacing or margin (dashed enclosed region) is provided between the local interconnect M0A on top of the PV and the neighbouring M0A. As a result, the width dimension of the PV (along the X-axis) is relatively small compared to the corresponding width dimension of the BPR. The PV may thus provide a relatively high resistance connection between the local interconnect M0A and the BPR. In a standard cell circuit, this additional spacing may typically be disposed at the boundary between two neighbouring circuit cells.

Fig. 2 shows a schematic cross-section of a corresponding semiconductor device 200 comprising a BPR and a PV which may be formed using embodiments of the present invention. As seen in the dashed enclosed region the additional lateral spacing or margin is here considerably reduced compared to Fig. 1. That is, the local interconnect M0A is further extended laterally (along the X-axis) towards the neighboring M0A. As a result, the width dimension of the PV (along the X-axis) is enlarged and may match or even exceed the corresponding width dimension of the BPR. Compared to Fig. 1, the PV may thus provide a relatively low resistance connection between the local interconnect M0A and the BPR.

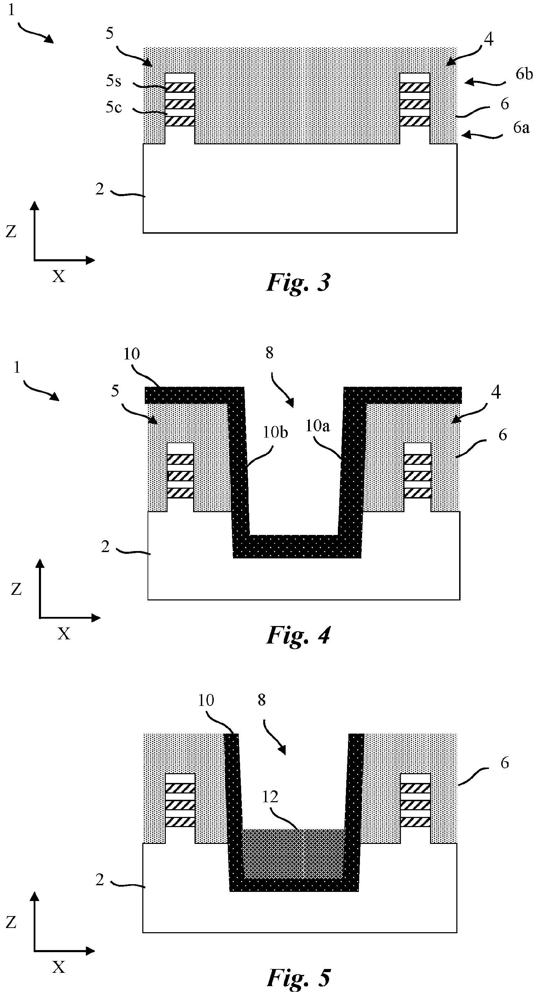

Fig. 3 shows a schematic cross-section of an initial or precursor structure 1, to be subjected to the processing steps of the method disclosed in the following.

The structure 1 comprises a substrate 2 and a first and second fin structure 4, 5 (interchangeably "fins"). The structure 1 is shown at a stage prior to front side device processing such as gate patterning and source/drain formation.

The substrate 2 may be a conventional substrate, e.g. a semiconductor substrate such as a Si substrate, a Ge substrate or a SiGe substrate. Other examples include a silicon-on-insulator (SOI) substrate, a GeOI substrate or a SiGeOI substrate.

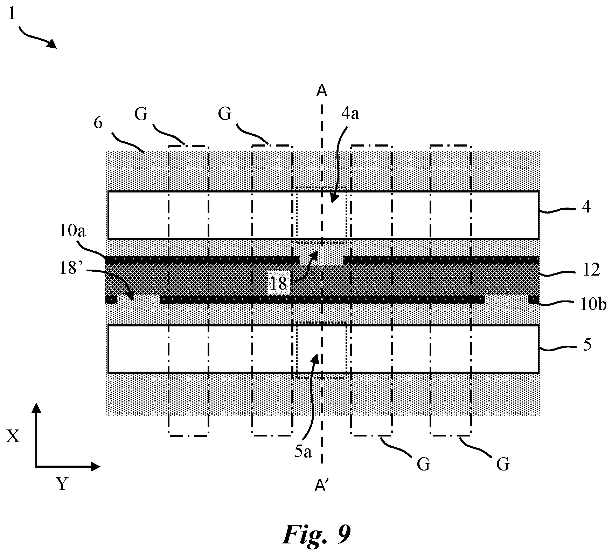

The fins 4, 5 protrude from the substrate 2, i.e. vertically along the Z-axis. The fins 4, 5 extend in parallel, along the Y-direction (see Fig. 9).

According to the illustrated example, the fins 4, 5 (as indicated for fin 5) each comprise an alternating stack of channel nanosheets 5c and sacrificial nanosheets 5s (e.g. of Si and SiGe, respectively). The fins 4, 5 are thus suitable precursors for forming Nanosheet-FETs. However, the method is equally applicable to fins 4, 5 formed as single semiconductor material bodies being suitable precursors for forming FinFETs (e.g. fins patterned in a single continuous layer of Si or SiGe). Fins for either Nanosheet-based FETs (e.g. Nanosheet-FETs, Forksheet FETs, CFETs) or FinFETs may be formed using any suitable conventional techniques, as per se are known in the art.

The method steps will be described in relation to the single pair of fins 4, 5 and for forming a single buried interconnect structure. However, as may be appreciated, the structure 1 may comprise a plurality of parallel fins 4, 5 and the method may be applied at a plurality of positions along the substrate 2, to form buried interconnect structures between a plurality of different pairs of fins.

An isolation layer structure 6 has further been formed to embed the fins 4, 5. The isolation layer structure 6 may comprise one or more dielectrics, e.g. including oxides such as SiO₂ or other low-k dielectrics. The isolation layer structure 6 may as indicated comprise an STI structure or portion 6a embedding a lower portion of the fins 4, 5 and an interlayer dielectric (ILD) layer 6b covering the STI structure 6a and embedding an upper portion of fins 4, 5. While not individually shown, the isolation structure 6 may as per se is known in the art further comprise one or more dielectric liners and/or a dummy oxide covering the fins.

In any case, a thickness of the isolation layer structure 6 may as shown exceed a height (along the Z-axis) of the fins 4, 5 over the substrate 2 such that a top surface of the isolation layer structure 6 (which may be planarized) is located over the fins 4, 5, i.e. such that the fins 4, 5 are completely embedded by the isolation layer structure 6.

Fig. 4 shows the structure 1 after forming a trench 8 for a buried interconnect structure in the isolation layer structure 6 and, subsequently, lining the trench 8 with a dielectric layer 10 (interchangeably "liner"). The trench 8 may as shown thus extend through the isolation layer structure 6, and optionally further into the substrate 2. The trench 8 may be elongated (e.g. along the Y-axis, see Fig. 9) and extend parallel to and along at least a portion of the length of the fins 4, 5. The trench 8 may be formed by lithography and etching. Any etching processes suitable for forming the trench 8 (which typically is of a high aspect ratio), may be used including e.g. an anisotropic dry etch such as reactive ion etching (RIE) or ion beam etching (IBE).

The liner 10 may be conformally deposited on the structure 1, e.g. by atomic layer deposition (ALD). The liner 10 may comprise one or more insulating materials, for instance SiN, SiO₂, SiC, SiCO or SiOCN. The liner material(s) may in general be selected as one or more materials that can be etched selectively to the material(s) of the isolation layer structure 6, so that a local interconnect trench 24 can be etched in the isolation layer structure 6 without causing any appreciable etching of the liner 10.

The dielectric layer / liner 10 lines (i.e. covers) the sidewalls and the bottom of the trench 8. The liner 10 comprises a first portion 10a and a second portion 10b formed along opposite first and second sidewalls of the trench 8.

Fig. 5 shows the structure 1 after forming a buried interconnect structure 12 in the trench 8. The buried interconnect structure 12 may as shown fill a bottom portion of the trench 8. A top surface of the buried interconnect structure 12 may as shown be located at a level below a top of the respective fins 4, 5. In the illustrated example the top surface of the buried interconnect structure 12 approximately coincides with a base of the fins 4, 5. However, in another examples the trench 8 may extend deeper into the substrate 2 and a thickness of the buried interconnect structure 12 may be such that the top surface of the buried interconnect structure 12 is located below the fins 4, 5 (i.e. the buried interconnect structure 2 may be fully submerged in the thickness of the substrate 2). In any case, the height of the buried interconnect structure 12 will typically be less than a depth of the trench 8 (after being lined with the liner 10), as seen along the Z-axis.

The buried interconnect structure 12 may be a conductive interconnect (e.g. a buried conductive interconnect line) comprising one or more conductive materials such as one or more metals. Example metals include Cu, W, Ru, Ni and Al. The metal(s) may be deposited by conventional deposition techniques such as chemical vapor deposition (CVD) or ALD. The conductive interconnect may further comprise a barrier metal such as TiN. The deposited conductive material(s) (e.g. metal(s)) may subsequently be recessed (e.g. by metal etch back) to a desired level. The buried interconnect structure 12 may in particular be a BPR, thus configured to be used for power delivery to the active devices in the finished circuit. However, other use cases for the buried interconnect structure 12 are also possible, such as for routing analog or digital signals.

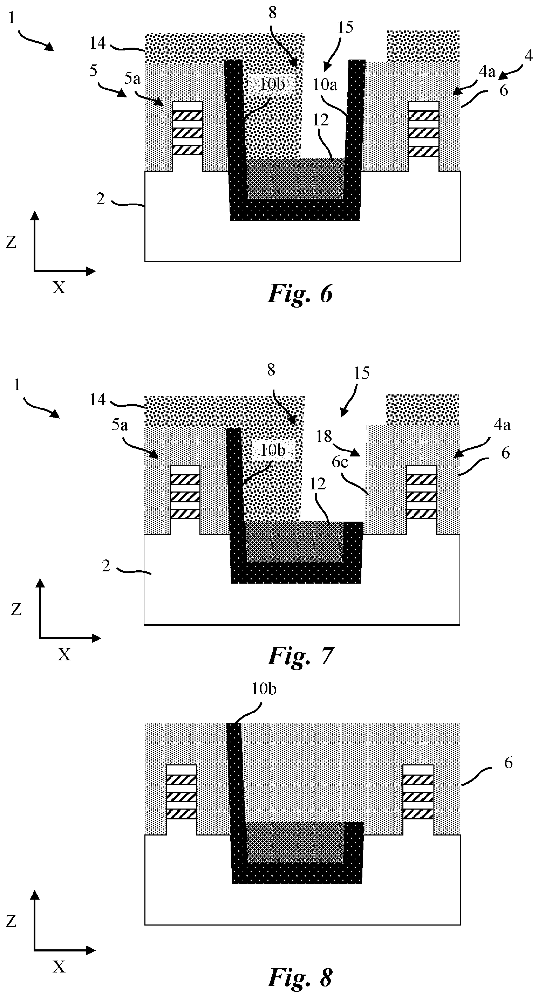

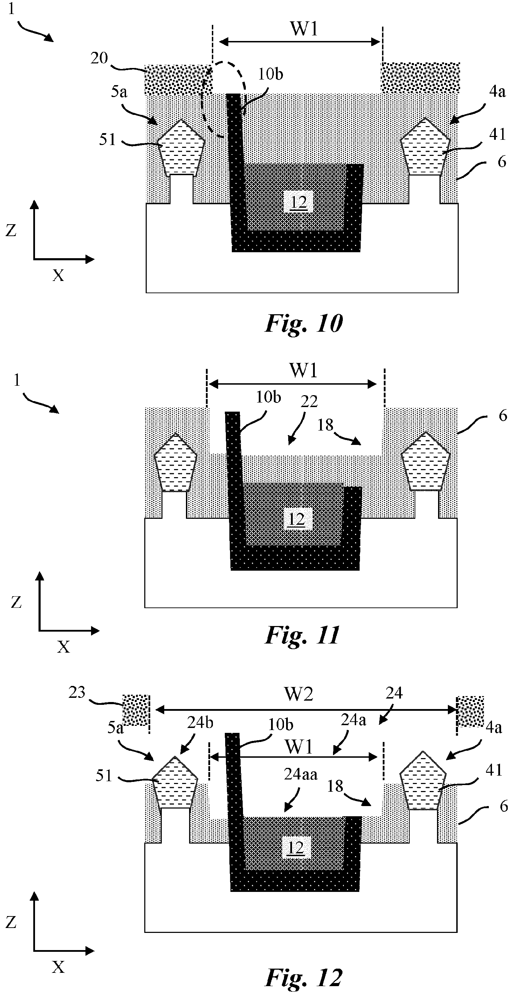

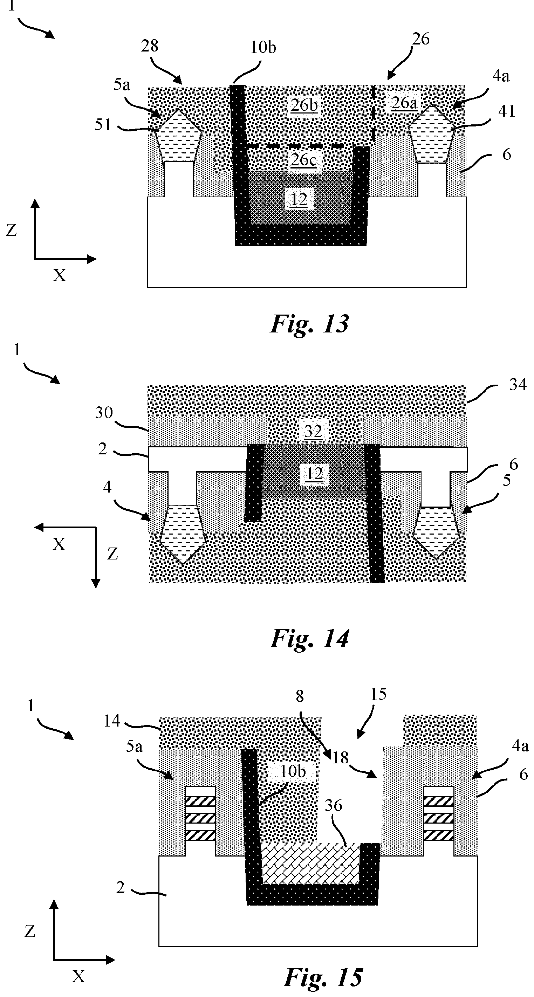

Fig. 6 shows the structure 1 after forming an etch mask 14 for etching a contact opening 18 (shown in Fig. 7) in the liner 10. The etch mask 14 may be a conventional lithographic layer stack, comprising e.g. a fill layer (e.g. spin-on-carbon), a patterning film and a photoresist on top. The etch mask 14 is patterned to define an opening 15 along a section of the first portion 10a of the liner 10. More specifically, the opening 15 is defined (i.e. selectively) along a section of the first portion 10a adjacent a first region 4a of the first fin 4. Meanwhile, the etch mask 14 covers the second portion 10b along a section of the liner 10 adjacent a second region 5a of the second fin 5, the second region 5a being directly opposite the first region 4a (i.e. as seen along a direction across the trench 8, that is along the X-axis). The first region 4a is a region in which a source/drain contact portion 26a of a first local interconnect 26 is to be formed and the second region 5a is a region in which a second local interconnect 28 is to be formed (see e.g. Fig. 13). Additionally, the first region 4a is a region in which a source/drain 41 for a first FET is to be formed and the second region 5a is a region in which a source/drain 51 for a second FET is to be formed (see e.g. Fig. 10).

Fig. 7 shows the structure 1 after forming the contact opening 18 by etching the liner 10 through the opening 15 in the etch mask 14. The contact opening 18 is formed in the first portion 10a of the dielectric layer 10 adjacent the first region 4a. Any suitable etching process, wet or dry, may be used. The opening 18 exposes a sidewall 6c of the isolation layer structure 6a along the first region 4a. While forming the contact opening 18, the buried interconnect structure 12 masks the dielectric layer 10 in the bottom portion of the trench 8.

Fig. 9 is a schematic top view of the structure 1 after forming the contact opening 18 and removing the etch mask 14. As shown in Fig. 9, corresponding contact openings 18' may be selectively formed in one or more further sections of the liner 10, including in sections of the second portion 10b of the liner 10. In particular, an opening 18, 18' may be formed in the liner 10 at each position along the trench 8 where a via connection between a local interconnect and the buried interconnect structure 12 is desired.

Fig. 8 shows the structure 1 after removing the etch mask 14 and filling the trench 8 with one or more dielectrics (e.g. one or more oxides such as SiO₂ or other low-k dielectrics) to thus restore the isolation layer structure 6 over the buried interconnect structure 12. After depositing the dielectric(s) the deposited dielectric(s) may be recessed and/or planarized (e.g by CMP and/or etch back) such that a top portion of the liner 10 (e.g. the second portion 10b) is exposed, as shown in Fig. 8.

Fig. 10-12 show process steps for forming a local interconnect trench 24 in the (restored) isolation layer structure 6. The process steps of Fig. 10-12 may as shown be performed at stage after the structure 1 has been subjected to gate patterning and source/drain formation (e.g. comprising fin recess and source/drain epitaxy). Accordingly, reference signs 41, 51 represent source/drains that have been formed in the first and second regions 4a, 5a of the fins 4, 5, respectively. The dashed-dotted outlines G schematically indicate approximate positions for gates. One or more of the gates may be cut to form disconnected gates on the first and second fins 4, 5. The gate patterning and source/drain formation may proceed in accordance with conventional front-end-of-line processing.

In Fig. 10 an etch mask 20 has been formed over the isolation layer structure 6. The etch mask 20 defines a first mask opening of width W1. The opening in the etch mask 20 may be formed along the contact opening 18 in the first portion 10a of the liner 10. That is, the opening in the etch mask 20 may be substantially aligned with the contact opening 18 along the longitudinal dimension of the trench 8 (along the Y-dimension). The opening in the etch mask 20 may for instance be approximately coextensive with the contact opening 18. The etch mask 20 may be formed as a conventional lithographic layer stack.

In Fig. 11 the opening in the etch mask 20 has been transferred into an upper thickness portion of the isolation layer structure 6 by etching back the isolation layer structure 6 through the first mask opening in the etch mask 20, thereby forming an initial local interconnect trench 22 with a width dimension substantially matching W1.

In Fig. 12 an etch mask 23 has been formed over the isolation layer structure 6. The etch mask 23 defines a second mask opening of width W2 overlapping (i.e. as seen along the vertical direction, that is along the Z-axis) the initial interconnect trench 22 and the first and second regions 4a, 5a. The local interconnect trench 24 has subsequently been formed by (further) etching back the isolation layer structure 6 through the second mask opening in the etch mask 23, thereby forming the local interconnect trench 24 with a width dimension substantially matching W2.

The local interconnect trench 24 extends between the first and second regions 4a, 5a and across the buried interconnect structure 12. The local interconnect trench 24 is formed by etching the isolation layer structure 6 selectively to the liner 10 such that the second portion 10b of the liner 10 is preserved in the local interconnect trench 24 to partition the local interconnect trench 24 into a first trench portion 24a and a second trench portion 24b. The etch back may proceed until the top surface of the buried interconnect structure 12 (e.g. conductive interconnect) is exposed and at least a top portion of the source/drains 41, 51, are exposed. The first trench portion 24a comprises a bottom portion 24aa having a bottom surface defined at least in part by the top surface of the buried interconnect structure 12.

The first trench portion 24a defines a portion for accommodating a first local interconnect 26 for connecting the source/drain 41 and the buried interconnect structure 12. Correspondingly, the second trench portion 24b defines a portion for accommodating a second local interconnect 28 for contacting the source/drain 51. The connection between the source/drain 41 and the buried interconnect structure 12 is facilitated by the contact opening 18 in the first portion 10a of the liner 10. That is, the first trench portion 24a extends through the contact opening 18.

As shown in Figs. 10-11, already the opening in the etch mask 20 and the initial local interconnect trench 22 may be defined to overlap the second portion 10b of the liner 10. This may provide overlay compensation in the sense of ensuring that the first trench portion 24a may expose the buried interconnect structure 12 along its full width dimension even if an overlay error occurs when patterning the etch mask 20.

As further shown in Figs. 10-11, the first mask opening W1 in the etch mask 20 may further overlap the contact opening 18 in the liner 10. That is, the first mask opening W1 may extend across the first portion 10a of the liner 10 and the contact opening 18. This allows a height dimension of the bridging portion 26b of the first local interconnect 26 (see Fig. 13) to be formed in the first trench portion 24a to be extended and, advantageously, match the depth/height of the contact opening 18.

In Fig. 12, the width dimension W2 of the second opening in the etch mask 23 corresponds approximately to the pitch of the fins 4, 5. However, in another example the width dimension W2 of the second opening may span across one or more additional fins, thereby allowing a "merged litho" (i.e. a simultaneous etching through the common second mask opening) of local interconnect trenches for three of more fins.

Owing to the two-step etch back approach for forming the local interconnect trench 24, the bottom surface of the bottom portion 24aa of the first trench portion 24a is located at a level below a bottom surface portion of the local interconnect trench 24 surrounding the source/drains 41, 51. The two-step etch back approach thus at least to some extent allows the depth of the local interconnect trench 24 at the first and second regions 4a, 5a to be controlled independently from the depth at the buried interconnect structure 12. While this in some cases may be beneficial to mitigate a risk of over etching the isolation layer structure 6 at the first and second regions 4a, 5a (potentially exposing the substrate 2), a two-step etch back approach may when sufficient vertical etch margin is present be replaced with a single-step etch to directly form the local interconnect trench 24.

Fig. 13 shows the structure 1 after removing the etch mask 23 and forming first and second local interconnects 26, 28 in the first and second trench portions 24a-b of the local interconnect trench 24.

The first and second local interconnects 26, 28 are separated by the second portion 10b of the liner 10. The second local interconnect 28 contacts the source/drain 51 formed in the second region 5a of the second fin 5. The first local interconnect 26 comprises: a source/drain contact portion 26a contacting the source/drain 41 formed in the first region 4a of the fin 4, a via portion 26c (e.g. formed in the bottom portion 24aa of the first trench portion 24a) contacting the buried interconnect structure 12, and a bridging portion 26b extending between the source/drain contact portion 26a and the via portion 26c through the contact opening 18. The first local interconnect 26 thus interconnects the source/drain 41 and the buried interconnect structure 12. Due to the lateral isolation margin provided by the second portion 10b of the liner 10, the bridging portion 26b and the via portion 26c may both be laterally extended (along the X-axis) to span and thus interface with the full width dimension of the buried interconnect structure 12. This enables a low resistance connection between the source/drain 41 and the buried interconnect structure 12, even at aggressive contact and fin pitches.

The first and second local interconnects 26, 28 may be formed by depositing one or more contact metals filling the first and second trench portions 24a-b. Examples of contact metals include metals conventionally used for source/drain contacts, such as W and Al, optionally preceded by a metal liner, such as TiN. The contact metal(s) may be deposited by CVD and/or ALD. After metal deposition, overburden metal may be removed by a planarization and metal recess process (e.g. CMP and/or metal etch back), stopping on the top portion of the second portion 10b of the liner 10 to separate the metal(s) into discrete local interconnects 26, 28.

As may be appreciated in view of Fig. 2, the source/drain contact portion 28, the source/drain contact portion 26a and the bridging portion 26b may form part of the M0A local interconnect level, while the via contact portion 26c may correspond to the PV vertically bridging the distance between the M0A level and the buried interconnect structure 12 (e.g. the BPR).

While reference signs 26a-c designate different portions of the first local interconnect 26, the first local interconnect 26 forms a continuous body of one or more metals. The dashed lines in Fig. 13 indicating the division between the portions 26a-c do hence not represent any physical boundaries or partitions of the first local interconnect 26, but are merely added to facilitate understanding of the physical extension of the first local interconnect 26.

Fig. 14 shows the structure 1 after flipping the substrate 2 and forming a backside interconnect structure using backside processing. The backside processing may comprise thinning the substrate 2 from the backside to reveal a backside or underside of the buried interconnect structure 12. The backside processing may thereafter proceed with forming one or more backside interconnect levels, e.g. comprising deposition of ILD 30 and forming of TSVs 32 for contacting the buried interconnect structure 12, and backside interconnects 34 (e.g. using a dual damascene processing).

The person skilled in the art realizes that the present invention by no means is limited to the embodiments described above. On the contrary, many modifications and variations are possible within the scope of the appended claims.

For example, in the above, the method steps have been described in relation to a buried interconnect structure 12 in the form of a conductive interconnect (e.g. BPR). However, the method is also compatible with a replacement approach, wherein the buried interconnect structure 12 may be formed as a dummy structure of a dummy material (e.g. amorphous silicon) and then, after the substrate thinning of the backside processing, be removed using a selective etch and replaced with a final conductive interconnect (e.g. any of the example metals discussed in relation to the buried interconnect structure 12 above).

Fig. 15 shows the structure 1 in accordance with yet another variation of the above approach, wherein the contact opening 18 is formed prior to forming the buried interconnect structure 12 (which may be either a conductive interconnect or a dummy interconnect). In this case, a dedicated temporary block layer 36 may be formed to fill the bottom portion of the trench 8 prior to forming the etch mask 14. The temporary block layer 36 may thus mask the liner 10 formed along the sidewalls and bottom of the bottom portion of the trench 8 when etching the contact opening 18. The block layer 36 may subsequently be removed and replaced by the final conductive interconnect, a dummy structure of a dummy material as discussed above. The temporary block layer 36 may for instance be formed of spin-on-carbon material or some other material with sufficient etch contrast to the material of the liner 10, good fill properties, and which may be easily removed from the trench 8 without leaving any substantial residues.

## Claims

1. A method for forming a semiconductor device, the method comprising:
forming a trench (8) for a buried interconnect structure (12) at a position between a first and second fin structure (4, 5) extending in parallel along a substrate (2), wherein the trench (8) extends through an isolation layer structure (6) embedding the first and second fin structures (4, 5);
lining the trench (8) with a dielectric layer (10), the dielectric layer (10) comprising first and second portions (10a, 10b) formed along opposite first and second sidewalls of the trench (8);
after lining the trench (8), forming a buried interconnect structure (12) in the trench (8);
etching a contact opening (18) in the first portion (10a) of the dielectric layer (10) adjacent a first region (4a) of the first fin structure (4), while masking the second portion (10b) of the dielectric layer (10) adjacent a second region (5a) of the second fin structure (5) directly opposite the first region (4a);
after etching the contact opening (18), filling the trench (8) with a dielectric material to restore the isolation layer structure (6) over the buried interconnect structure (12);
forming a local interconnect trench (24) in the isolation layer structure (6), the local interconnect trench (24) extending between the first and second regions (4a, 5a) and across the buried interconnect structure (12), wherein the local interconnect trench (24) is formed by etching the isolation layer structure (6) selectively to the dielectric layer (10) such that the second portion (10b) of the dielectric layer (10) is preserved to partition the local interconnect trench (24) into a first trench portion (24a) for a first local interconnect (26) and a second trench portion (24b) for a second local interconnect (28), wherein the first trench portion (24a) extends through the contact opening (18) in the first portion (10a) of the dielectric layer (10); and
forming a first local interconnect (26) in the first trench portion (24a) and a second local interconnect (28) in the second trench portion (24b), wherein the first and second local interconnects (26, 28) are separated by the second portion (10b) of the dielectric layer (10), wherein the second local interconnect (28) contacts a source/drain (51) formed in the second region (5a) of the second fin structure (5), and wherein the first local interconnect (26) comprises a source/drain contact portion (26a) contacting a source/drain (41) formed in the first region (4a) of the first fin structure (4), a via portion (26c) contacting the buried interconnect structure (12), and a bridging portion (26b) extending between the source/drain contact portion (26a) and the via portion (26c) through the contact opening (18).

2. A method according to claim 1, wherein the buried interconnect structure (12) is a conductive buried interconnect.

3. A method according to claim 1, wherein the buried interconnect structure (12) is a buried dummy interconnect and the method comprises replacing the dummy buried interconnect with a conductive buried interconnect during backside processing.

4. A method according to claim 2 or 3, wherein the conductive buried interconnect is a buried power rail.

5. A method according to any one of the preceding claims, wherein forming the local interconnect trench (24) comprises:
forming an initial local interconnect trench (22) by etching back the isolation layer structure (6) through a first mask opening overlapping the buried interconnect structure (12), wherein the etch back is stopped prior to exposing the buried interconnect structure (12); and
forming the local interconnect trench (24) by etching back the isolation layer structure (6) through a second mask opening overlapping the initial interconnect trench (22) and the first and second regions (4a, 5a).

6. A method according to claim 5, wherein the first mask opening further overlaps the second portion (10b) of the dielectric layer (10).

7. A method according to claim 6, wherein the first mask opening further overlaps the contact opening (18) in the dielectric layer (10).

8. A method according to any one of the preceding claims, wherein the buried interconnect structure (12) is formed prior to forming the contact opening (18) in the dielectric layer (10).

9. A method according to claim 8, wherein, while forming the contact opening (18) in the dielectric layer (10), the dielectric layer (10) is masked in a bottom portion of the trench (8) by the buried interconnect structure (12).

10. A method according to any one of claims 1-7, wherein the buried interconnect structure (12) is formed subsequent to forming the contact opening (18) in the dielectric layer.

11. A method according to claim 10, wherein, while forming the contact opening (18) in the dielectric layer (10), the dielectric layer (10) is masked in a bottom portion of the trench (8) by a temporary block layer (36).

12. A method according to any one of the preceding claims, wherein the isolation layer structure (6) comprises a shallow trench isolation structure (6a) embedding a lower portion of the fin structures (4, 5) and an interlayer dielectric layer (6b) covering the shallow trench isolation structure (6a) and embedding an upper portion of fin structures (4, 5).

13. A method according to any one of the preceding claims, wherein the trench (8) further extends into the substrate (2).

14. A method according to any one of the preceding claims, further comprising processing the first and second fin structures (4, 5) to form gates across a channel region of the first and second fin structures (4, 5) and source/drains (41, 51) in the first and second regions (4a, 5a) of the first and second fin structures (4, 5), wherein the contact opening (18) is formed prior to the processing of the first and second fin structures (4, 5).

## Patentansprüche

1. Verfahren zum Bilden eines Halbleiterbauelements, wobei das Verfahren umfasst:
Bilden eines Grabens (8) für eine vergrabene Zusammenschaltungsstruktur (12) in einer Position zwischen einer ersten und einer zweiten Finnenstruktur (4, 5), die sich parallel entlang eines Substrats (2) erstrecken, wobei sich der Graben (8) durch eine Isolierschichtstruktur (6) hindurch erstreckt, welche die erste und die zweite Finnenstruktur (4, 5) einbetten;
Auskleiden des Grabens (8) mit einer dielektrischen Schicht (10), wobei die dielektrische Schicht (10) erste und zweite Abschnitte (10a, 10b) umfasst, die entlang gegenüberliegenden ersten und zweiten Seitenwänden des Grabens (8) gebildet sind;
nach dem Auskleiden des Grabens (8), Bilden einer vergrabenen Zusammenschaltungsstruktur (12) in dem Graben (8);
Ätzen einer Kontaktöffnung (18) in dem ersten Abschnitt (10a) der dielektrischen Schicht (10), die an eine erste Region (4a) der ersten Finnenstruktur (4) angrenzend ist, während der zweite Abschnitt (10b) der dielektrischen Schicht (10), der an eine zweite Region (5a) der zweiten Finnenstruktur (5) direkt gegenüber der ersten Region (4a) angrenzend ist, maskiert wird;
nach dem Ätzen der Kontaktöffnung (18), Ausfüllen des Grabens (8) mit einem dielektrischen Material, um die Isolierschichtstruktur (6) über der vergrabenen Zusammenschaltungsstruktur (12) wiederherzustellen;
Bilden eines lokalen Zusammenschaltungsgrabens (24) in der Isolierschichtstruktur (6), wobei sich der lokale Zusammenschaltungsgraben (24) zwischen der ersten und der zweiten Region (4a, 5a) und über die vergrabene Zusammenschaltungsstruktur (12) erstreckt, wobei der lokale Zusammenschaltungsgraben (24) durch selektives Ätzen der Isolierschichtstruktur (6) in der dielektrischen Schicht (10) gebildet wird, so dass der zweite Abschnitt (10b) der dielektrischen Schicht (10) beibehalten wird, um den lokalen Zusammenschaltungsgraben (24) in einen ersten Grabenabschnitt (24a) für eine erste lokale Zusammenschaltung (26) und einen zweiten Grabenabschnitt (24b) für eine zweite lokale Zusammenschaltung (28) zu partitionieren, wobei sich der erste Grabenabschnitt (24a) durch die Kontaktöffnung (18) in dem ersten Abschnitt (10a) der dielektrischen Schicht (10) hindurch erstreckt; und
Bilden einer ersten lokalen Zusammenschaltung (26) in dem ersten Grabenabschnitt (24a) und einer zweiten lokalen Zusammenschaltung (28) in dem zweiten Grabenabschnitt (24b), wobei die erste und die zweite lokale Zusammenschaltung (26, 28) durch den zweiten Abschnitt (10b) der dielektrischen Schicht (10) getrennt sind, wobei die zweite lokale Zusammenschaltung (28) eine Source/ einen Drain (51) kontaktiert, die/der in der zweiten Region (5a) der zweiten Finnenstruktur (5) gebildet ist, und wobei die erste lokale Zusammenschaltung (26) einen Source-/Drain-Kontaktabschnitt (26a) umfasst, der eine Source/ einen Drain (41), die/der in der ersten Region (4a) der ersten Finnenstruktur (4) gebildet ist, über einen Abschnitt (26c), der die vergrabene Zusammenschaltungsstruktur (12) kontaktiert, und einen Überbrückungsabschnitt (26b), der sich zwischen dem Source-/Drain-Kontaktabschnitt (26a) und dem Durchgangslochabschnitt (26c) durch die Kontaktöffnung (18) hindurch erstreckt, kontaktiert.

2. Verfahren nach Anspruch 1, wobei die vergrabene Zusammenschaltungsstruktur (12) eine leitfähige vergrabene Zusammenschaltung ist.

3. Verfahren nach Anspruch 1, wobei die vergrabene Zusammenschaltungsstruktur (12) eine vergrabene Dummy-Zusammenschaltung ist, und das Verfahren das Ersetzen der vergrabenen Dummy-Zusammenschaltung durch eine leitfähige vergrabene Zusammenschaltung während einer Rückseitenverarbeitung umfasst.

4. Verfahren nach Anspruch 2 oder 3, wobei die leitfähige vergrabene Zusammenschaltung eine vergrabene Stromschiene ist.

5. Verfahren nach einem der vorhergehenden Ansprüche, wobei das Bilden des lokalen Zusammenschaltungsgrabens (24) umfasst:
Bilden eines anfänglichen lokalen Zusammenschaltungsgrabens (22) durch Rückätzen der Isolierschichtstruktur (6) durch eine erste Maskenöffnung hindurch, die sich mit der vergrabenen Zusammenschaltungsstruktur (12) überlappt, wobei das Rückätzen vor dem Freilegen der vergrabenen Zusammenschaltungsstruktur (12) angehalten wird; und
Bilden des lokalen Zusammenschaltungsgrabens (24) durch Rückätzen der Isolierschichtstruktur (6) durch eine zweite Maskenöffnung hindurch, die sich mit dem anfänglichen Zusammenschaltungsgraben (22) und der ersten und der zweiten Region (4a, 5a) überlappt.

6. Verfahren nach Anspruch 5, wobei sich die erste Maskenöffnung ferner mit dem zweiten Abschnitt (10b) der dielektrischen Schicht (10) überlappt.

7. Verfahren nach Anspruch 6, wobei sich die erste Maskenöffnung ferner mit der Kontaktöffnung (18) in der dielektrischen Schicht (10) überlappt.

8. Verfahren nach einem der vorhergehenden Ansprüche, wobei die vergrabene Zusammenschaltungsstruktur (12) vor dem Bilden der Kontaktöffnung (18) in der dielektrischen Schicht (10) gebildet wird.

9. Verfahren nach Anspruch 8, wobei während des Bildens der Kontaktöffnung (18) in der dielektrischen Schicht (10), die dielektrische Schicht (10) in einem Bodenabschnitt des Grabens (8) durch die vergrabene Zusammenschaltungsstruktur (12) maskiert wird.

10. Verfahren nach einem der Ansprüche 1 bis 7, wobei die vergrabene Zusammenschaltungsstruktur (12) im Anschluss an das Bilden der Kontaktöffnung (18) in der dielektrischen Schicht gebildet wird.

11. Verfahren nach Anspruch 10, wobei während des Bildens der Kontaktöffnung (18) in der dielektrischen Schicht (10) die dielektrische Schicht (10) in einem Bodenabschnitt des Grabens (8) durch eine provisorische Blockierungsschicht (36) maskiert wird.

12. Verfahren nach einem der vorhergehenden Ansprüche, wobei die Isolierschichtstruktur (6) eine seichte Grabenisolierstruktur (6a), die einen unteren Abschnitt der Finnenstrukturen (4, 5) einbettet, und eine dielektrische Schicht (6b) zwischen den Schichten, welche die seichte Grabenisolierstruktur (6a) abdeckt und einen oberen Abschnitt der Finnenstrukturen (4, 5) einbettet, umfasst.

13. Verfahren nach einem der vorhergehenden Ansprüche, wobei sich der Graben (8) weiter in das Substrat (2) hinein erstreckt.

14. Verfahren nach einem der vorhergehenden Ansprüche, ferner umfassend das Verarbeiten der ersten und der zweiten Finnenstruktur (4, 5), um Gates über eine Kanalregion der ersten und der zweiten Finnenstruktur (4, 5) und Sources/Drains (41, 51) in der ersten und der zweiten Region (4a, 5a) der ersten und der zweiten Finnenstruktur (4, 5) zu bilden, wobei die Kontaktöffnung (18) vor dem Verarbeiten der ersten und der zweiten Finnenstruktur (4, 5) gebildet wird.

## Revendications

1. Procédé de fabrication d'un dispositif semi-conducteur, le procédé comprenant les étapes suivantes :
la formation d'une tranchée (8) destinée à recevoir une structure d'interconnexion enterrée (12) à une position entre une première et une deuxième structure à ailettes (4, 5) parallèles à un substrat (2), dans lequel la tranchée (8) traverse une structure de couche d'isolation (6) intégrant les première et deuxième structures à ailettes (4, 5) ;
le revêtement de la tranchée (8) par une couche diélectrique (10), la couche diélectrique (10) comportant une première et une deuxième partie (10a, 10b) formées le long des parois opposées de la tranchée (8) ;
après le revêtement de la tranchée (8), la formation d'une structure d'interconnexion enterrée (12) dans la tranchée (8) ;
la gravure d'une ouverture de contact (18) dans la première partie (10a) de la couche diélectrique (10) adjacente à une première région (4a) de la première structure d'ailette (4), tout en masquant la deuxième partie (10b) de la couche diélectrique (10) adjacente à une deuxième région (5a) de la deuxième structure d'ailette (5) directement opposée à la première région (4a) ;
après la gravure de l'ouverture de contact (18), le remplis5age de la tranchée (8) avec un matériau diélectrique pour restaurer la structure de couche d'isolation (6) au-dessus de la structure d'interconnexion enterrée (12) ;
la formation d'une tranchée d'interconnexion locale (24) dans la structure de couche d'isolation (6), la tranchée d'interconnexion locale (24) s'étendant entre la première et la deuxième région (4a, 5a) et à travers la structure d'interconnexion enterrée (12), dans lequel la tranchée d'interconnexion locale (24) est formée en gravant la structure de couche d'isolation (6) de manière sélective à la couche diélectrique (10) de sorte que la deuxième partie (10b) de la couche diélectrique (10) soit préservée pour partitionner la tranchée d'interconnexion locale (24) en une première partie de tranchée (24a) pour une première interconnexion locale (26) et une deuxième partie de tranchée (24b) pour une deuxième interconnexion locale (28), dans lequel la première partie de tranchée (24a) s'étend à travers l'ouverture de contact (18) dans la première partie (10a) de la couche diélectrique (10) ; et
la formation d'une première interconnexion locale (26) dans la première partie de tranchée (24a) et d'une deuxième interconnexion locale (28) dans la deuxième partie de tranchée (24b), dans lequel les première et deuxième interconnexions locales (26, 28) sont séparées par la deuxième partie (10b) de la couche diélectrique (10), dans lequel la deuxième interconnexion locale (28) est en contact avec une source/drain (51) formée dans la deuxième région (5a) de la deuxième structure d'ailette (5) et la première interconnexion locale (26) comprend une partie de contact source/drain (26a) en contact avec une source/drain (41) formée dans la première région (4a) de la première structure d'ailette (4), une partie de via (26c) en contact avec la structure d'interconnexion enterrée (12), et une partie de pontage (26b) s'étendant entre la partie de contact source/drain (26a) et la partie de via (26c) à travers l'ouverture de contact (18).

2. Procédé selon la revendication 1, dans lequel la structure d'interconnexion enterrée (12) est une interconnexion enterrée conductrice.

3. Procédé selon la revendication 1, dans lequel la structure d'interconnexion enterrée (12) est une interconnexion enterrée factice et le procédé comprend le remplacement de l'interconnexion enterrée factice par une interconnexion enterrée conductrice lors du traitement de la face arrière.

4. Procédé selon la revendication 2 ou 3, dans lequel l'interconnexion enterrée conductrice est un rail d'alimentation enterré.

5. Procédé selon une quelconque des revendications précédentes, dans lequel la formation de la tranchée d'interconnexion locale (24) comprend :
la formation d'une tranchée d'interconnexion locale initiale (22) par gravure de la structure de couche d'isolation (6) à travers une première ouverture de masque superposée à la structure d'interconnexion enterrée (12), dans lequel la gravure est arrêtée avant l'exposition de la structure d'interconnexion enterrée (12) ; et
la formation de la tranchée d'interconnexion locale (24) en gravant la structure de couche d'isolation (6) à travers une deuxième ouverture de masque superposée à la tranchée d'interconnexion initiale (22) et les première et deuxième régions (4a, 5a).

6. Procédé selon la revendication 5, dans lequel la première ouverture de masque se superpose en outre à la deuxième partie (10b) de la couche diélectrique (10).

7. Procédé selon la revendication 6, dans lequel la première ouverture de masque se superpose en outre à l'ouverture de contact (18) dans la couche diélectrique (10).

8. Procédé selon une quelconque des revendications précédentes, dans lequel la structure d'interconnexion enterrée (12) est formée avant la formation de l'ouverture de contact (18) dans la couche diélectrique (10).

9. Procédé selon la revendication 8, dans lequel, lors de la formation de l'ouverture de contact (18) dans la couche diélectrique (10), la couche diélectrique (10) est masquée dans une partie inférieure de la tranchée (8) par la structure d'interconnexion enterrée (12).

10. Procédé selon une quelconque des revendications 1 à 7, dans lequel la structure d'interconnexion enterrée (12) est formée après la formation de l'ouverture de contact (18) dans la couche diélectrique.

11. Procédé selon la revendication 10, dans lequel, lors de la formation de l'ouverture de contact (18) dans la couche diélectrique (10), la couche diélectrique est masquée dans une partie inférieure de la tranchée (8) par une couche de blocage temporaire (36).

12. Procédé selon une quelconque des revendications précédentes, dans lequel la structure de couche d'isolation (6) comprend une structure d'isolation par tranchée peu profonde (6a) intégrant une partie inférieure des structures d'ailettes (4, 5) et une couche diélectrique intermédiaire (6b) recouvrant la structure d'isolation par tranchée peu profonde (6a) et intégrant une partie supérieure des structures d'ailettes (4, 5).

13. Procédé selon une quelconque des revendications précédentes, dans lequel la tranchée (8) se prolonge dans le substrat (2).

14. Procédé selon une quelconque des revendications précédentes, comprenant en outre le traitement des première et deuxième structures d'ailettes (4, 5) pour former des grilles au travers d'une région de canal des première et deuxième structures d'ailettes (4, 5) et des sources/drains (41, 51) dans les première et deuxième régions (4a, 5a) des première et deuxième structures d'ailettes (4, 5), dans lequel l'ouverture de contact (18) est formée avant le traitement des première et deuxième structures d'ailettes (4, 5).
